**Europäisches Patentamt**

**European Patent Office**

**Office européen des brevets**

(19)

(11) Publication number:

**0 138 863**

**B1**

(12)

# EUROPEAN PATENT SPECIFICATION

(45) Date of publication of patent specification: **02.03.88**

(51) Int. Cl.⁴: **H 05 K 13/04**

(21) Application number: **84901000.4**

(22) Date of filing: **07.03.84**

(86) International application number:
**PCT/GB84/00072**

(87) International publication number:
**WO 84/03602 13.09.84 Gazette 84/22**

(54) **ASSEMBLING COMPONENTS ON A PRINTED CIRCUIT BOARD.**

(30) Priority: **08.03.83 GB 8306416**

(43) Date of publication of application:
**02.05.85 Bulletin 85/18**

(45) Publication of the grant of the patent:
**02.03.88 Bulletin 88/09**

(84) Designated Contracting States:
**AT BE CH DE FR GB LI LU NL SE**

(56) References cited:
**EP-A-0 062 335**
**DE-A-3 022 803**

(73) Proprietor: **AMBOTECH LIMITED**
**Icen House Icen Way**
**Dorchester Dorset DT1 1ES (GB)**

(72) Inventor: **NOBLE, Peter, John, Wellesley 7 Trent**
**Close**
**Tolpuddle**
**Dorchester, Dorset DT2 7HA (GB)**

(74) Representative: **Meddle, Alan Leonard et al**
**FORRESTER & BOEHMERT Widenmayerstrasse**
**4/I**
**D-8000 München 22 (DE)**

Courier Press, Leamington Spa, England.

# Description

This invention relates to assembling printed circuit boards, in particulr to apparatus for and a method of assembling components on a printed circuit board.

In the past, components have been manually assembled onto printed circuit boards. However, manual assembly of printed circuit boards is both slow and laborious and mechanical devices have, accordingly, been devised for automatically assembling components on printed circuit boards. EP—A—0062335 discloses one known device in which an output from a first image pick-up device, which images a portion of a circuit board, is processed by a signal processor in order to detect any deviations in the position of the circuit board from a reference position, and the output from a second image pick-up device, which images a portion of a component to be inserted into the printed circuit board, is processed by the processor in order to detect any deviations in the position of the component from the predetermined position of the circuit board. A positioning device controlled by the signal processor adjusts the predetermined position of the circuit board to a position opposite the component and also moves the component towards the circuit board.

Another device is disclosed in DE—A—3022803, in which a component insertion head comprises a first fixed half and a second movable half displaceable on a guide axis. In use, a printed circuit board is moved under program control and brought into a component insertion position. Meanwhile, scanning data for the components is input to the apparatus. The component to be inserted is then centred on the two head halves in order that it leads lie on sliders of the head halves. The leads are then cut and bent by respective cutting and bending arms of the head halves and are deflected around the sliders in order that each lead enters a respective guide slot of the respective head halves. On completion of this, the sliders are moved away and the component is clamped between the guide slots. By further downward movement of the cutting and bending arms, component guide and positioning arms are brought into engagement with the component. This movement continues until the guide slots reach the printed circuit board upper surface. The position of the printed circuit board is then corrected in order that the component is inserted in the holes of the printed circuit board by means of a single downward movement of the insertion arm.

In order to ensure that the components are accurately located on the circuit board by the known devices, the printed circuit boards and the mechanical assembly means must be manufactured to a high degree of accuracy and, moreover, a printed circuit board must be precisely positioned relative to the mechanical means during assembly of the components on the printed circuit board. The necessity for such high accuracy leads of course to high costs. Moreover, because any slight inaccuracies in the positioning or manufacture of the printed circuit boards and in the manufacture of the mechanical assembly means will result in errors being made during the assembly, the number of reject finished printed circuit boards will be high.

It is an object of the present invention to overcome, or at least mitigate, the disadvantages of the previously proposed methods and apparatus.

According to one aspect of the present invention, there is provided apparatus for preparing a component for assembly on a printed circuit board, comprising: sensing means for sensing the pattern of component lead receiving apertures on the circuit board at a desired location of a particular component; means for comparing the pattern sensed with a master pattern stored in memory means to produce a difference signal; and control means for controlling a preforming means in accordance with the difference signal to preform the leads of the component to fit the sensed pattern of component lead receiving apertures.

In a preferred embodiment of the invention, the apparatus comprises: means for effecting relative movement between a component insertion device and the printed circuit board to position the component insertion device above an area of the printed circuit board containing the desired location of the component carried by the component insertion device; sensing means for producing an image of the said area; means for comparing the image sensed with a correct image stored in memory means to produce a difference signal; and control means for controlling the moving means in response to the difference signal to position the component insertion device directly over the desired location of the component.

Thus, the present invention enables components to be assembled with speed and precision on a printed circuit board so that the number of reject finished printed circuit boards is minimised.

Preferably, the apparatus further comprises means for storing data representing a component to be inserted in the printed circuit board and means for comparing an image of the component produced by the sensing means with the stored data to calibrate the sensing means prior to assembly of components on the printed circuit board. Such calibration thus prevents the production of incorrect difference signals which may be caused by, for example, incorrect mounting of the sensing means in the apparatus by compensating for the error produced by the sensing means.

Suitably, the apparatus also comprises means for storing data representing a plurality of preselected locations on the printed circuit board, means for comparing an image of the stored data representing the preselected locations to produce a signal to cause the control means to effect relative movement between the printed circuit board and the component insertion device to position the printed circuit board correctly prior to assembly of components on the printed circuit board.

According to a second aspect of the present invention, there is provided a method of preparing a component for assembly on a printed circuit board, comprising: sensing the pattern of component lead receiving apertures at a desired location of a particular component; comparing the pattern sensed with a master pattern stored in memory means to produce a difference signal; and controlling a preforming means in accordance with the difference signal to preform the leads of component to fit the sensed pattern of component lead receiving apertures.

In a preferred embodiment of the invention, the method comprises: effecting relative movement between a component insertion device and the printed circuit board using moving means to position the component insertion device above an area of the printed circuit board containing the desired location of a component carried by the component insertion device; producing an image of the said area using sensing means; comparing the image sensed with a correct image stored in memory means to produce a difference signal; and controlling the moving means in response to the difference signal to position the component insertion device directly over the desired location of the component.

Preferably the method further comprises, prior to assembling components on a printed circuit board, storing data representing a component to be inserted in the printed circuit board and comparing the stored data with an image of the component produced by the sensing means to calibrate the sensing means. Normally, the method also comprises storing data representing a plurality of preselected locations on the printed circuit board, comparing an image of the preselected locations produced by the sensing means with the stored data representing the locations to produce a signal to cause the control means to effect relative movement between the printed circuit board and the component insertion device to position the printed circuit board correctly prior to assembly of components on the printed circuit board.

In a preferred embodiment, the sensing means comprises a photosensitive array, for example, an array of photosensitive device and an imaging lens or lens system. Usually the apparatus is controlled by a microprocessor and normally the apparatus will have a plurality, for example five, of insertion devices, each insertion device being associated with a respective sensing means.

For a better understanding of the present invention and to show how the same may be put into effect, reference will now be made, by way of example, to the accompanying drawings, in which:

FIGURE 1 is a schematic block diagram of apparatus embodying the invention;

FIGURE 2 illustrates the positioning of a sensor head of the apparatus over a printed circuit board.

FIGURE 3 is a schematic plan view of a first target area viewed by the sensor head on a printed circuit board; and

FIGURE 4 is a schematic plan view of a second target area on a printed circuit board viewed by the sensor.

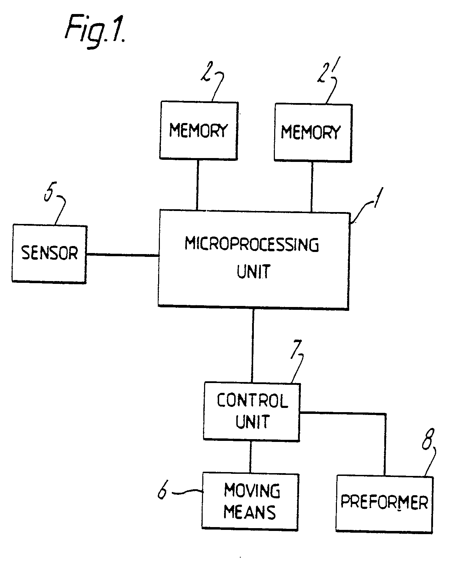

Referring now to the drawings, Figure 1 is a schematic block diagram of apparatus embodying the invention.

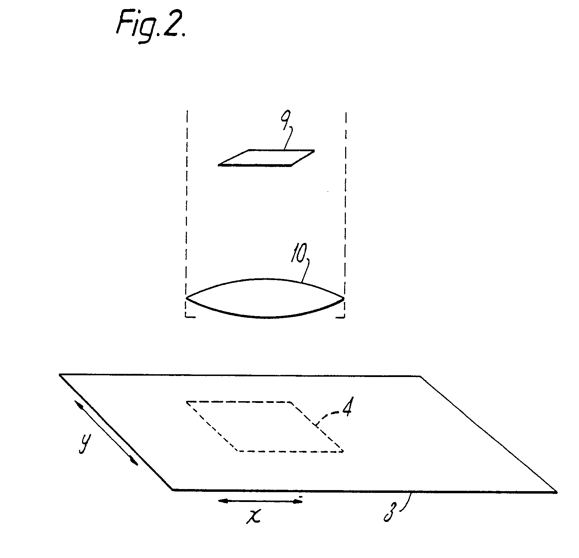

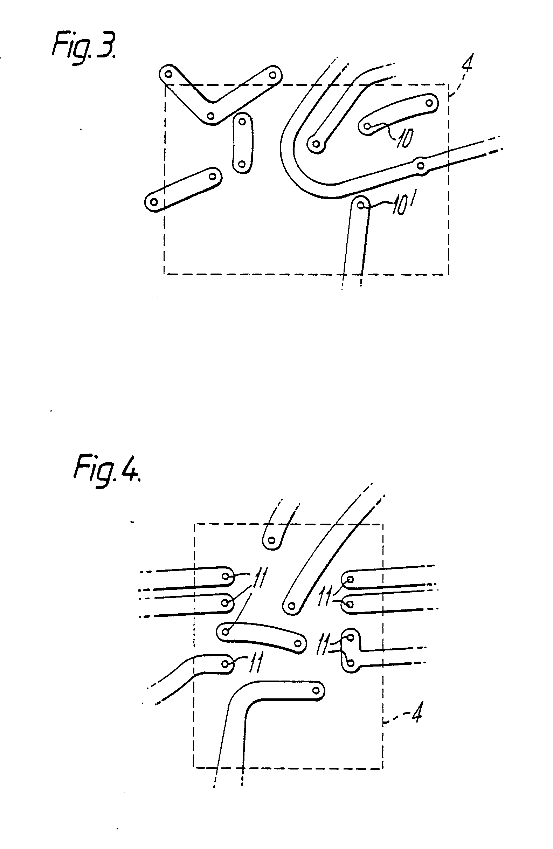

The apparatus comprises a microprocessor 1 having a memory 2 in which the master layout of a printed circuit board 3 (Figure 2) is stored as a plurality of master images, each master image representing a particular target area 3 of the printed circuit board. The memory 2 is preferably an alterable non-volatile solid state memory such as electrically alterable programmable memory (EAROM). Alternatively, the memory could comprise battery-backed up random access memory (RAM). A sensor head 5 is mounted in mechanical moving means 6. Movement of the mechanical moving means 6 is controlled by a control unit 7 under instruction from the microprocessing unit 1. The control unit 7, or alternatively a separate control unit, also controls a preforming device 8 for adjusting the relative orientation and position of the leads of a component to be inserted in the printed circuit board.

As shown schematically in Figure 2, the sensor head 5 comprises a photosensitive array 9 which has an array of photodiodes, a vidicon or similar photosensitive device and an imaging lens of lens system 10.

In operation of the apparatus, a printed circuit board on which components are to be assembled is positioned beneath the sensor head 5 and, under programmed instructions, the microprocessor 1 causes the mechanical moving means 6, which is preferably an electro-mechanical moving means, to move the sensor head over the printed circuit board 3 to position it above a target area 4 in which the first component to be assembled onto the printed circuit board is to be inserted. The lens system 10 focuses an image of the target area 4 onto the photosensitive array 9 and the signals output from the elements of the photosensitive array 9 are input to the microprocessor unit 1 to provide a digital representation of the target area. The microprocessor 1 compares the digital signals representing the image sensed with signals stored in the memory representing the master image of that particular target area to produce difference signals. The microprocessor 1 the causes the control unit 7 to move the electro-mechanical moving means 6 in accordance with the difference signals so as to position a component insertion device (not shown) directly over the desired location of the component carried thereby. Alternatively, the printed circuit board may be moved to position the component insertion device over the desired component location. As shown in Figure 3, the desired location is provided by the component lead receiving apertures 10.

The microprocessor 1 may also be provided with a second memory 2' in which signals representing a master image of the pattern of component lead receiving apertures at a particular component location on the printed circuit board 3 are stored. In such a case, the microprocessor 1 will compare the pattern of component lead receiving apertures sensed by the sensor head 5 with the corresponding master pattern stored in the memory 2' to produce difference signals to instruct the control unit 7 (or a separate control unit) to cause a preforming unit 8 to preform the leads of a component to fit the stored pattern of lead receiving apertures, Figure 4 shows one such pattern of lead receiving apertures formed by the apertures 11.

Once a component has been correctly inserted in the printed circuit board, the microprocessor will instruct the control unit 7 to cause the mechanical moving means 6 to move the sensor head 5 to a position over the next target area 4 and the above described procedures will be repeated for the next target area. It should be noted that, when the microprocessor 1 compares a master pattern of component lead receiving apertures with the pattern sensed, the microprocessor will ignore any apertures which are not designed to accept a lead of the component which is being inserted even when the additional apertures occur within the pattern area.

In practice, the apparatus will include a number of insertion devices (not shown) each with an associated sensor head. Preferably, five insertion devices are used.

The apparatus should be self-aligning and each of the insertion devices should be independently alignable.

Because of errors which may be introduced due to tolerances in machining, assembly etc of the apparatus and errors in the printed circuit board, an initial calibration of the apparatus should be carried out. Recalibration will be necessary when an insertion device or sensor head is changed during the life of the apparatus.

The calibration is carried out by aligning each insertion device to the printed circuit board. A 'standard' component of known 'pitch' or length is inserted into the insertion device, illuminated and viewed by the associated sensor head 5 so that the pitch of the component is stored by the microprocessor unit. The insertion device is then aligned precisely with a known pair of holes on the printed circuit board so that the standard component may be inserted. The microprocessor unit 1 then computes the coordinate centres of the pairs of holes. The difference between the known pitch stored by the microprocessor and the pitch sensed by the sensor head 5 is then determiend so that any magnification errors can be compensated for. This pitch correction is stored by the microprocessor unit 1 together with the coordinate position of one of the holes, that is the "mechanical earth", so that any X—Y errors can be compensated for. The actual pitch centreline, that is the line between the two holes, is also stored so that compensation can be made for any angular errors. This stored data thus enables prevention of the production of incorrect error signals when, for example, the sensor head is titled when inserted into the apparatus and the magnification produced thereby is incorrect.

The above-described initialisation procedure is carried out for each insertion device. The apparatus may then be used as described above to assemble components on a printed circuit board, the microprocessor unit 1 being provided with data indicating the pitch of a component to be inserted and the insertion device to be used.

The printed circuit board will normally, be aligned in the apparatus by 'dead reckoning' so that the 'mechanical earth' will be in the target area of the sensor head 5 associated with an insertion device. The pitch information provided to the microprocessor determines the target area or 'window' of the sensor head 5. The mechanical moving means 6 moves the printed circuit board relative to the insertion device in accordance with the pitch information provided to the microprocessor circuit 1 from its memory 2. When the mechanical moving means 6 stops, the sensor head 5 'looks' at the target area and the image seen is impaired with that stored in the memory 2 to determine any coordinate errors for the 'mechanical earth' and the other holes so that the microprocessor unit 1 can compute any angular error of the printed circuit board and any X—Y error in the positioning of the printed circuit board and thereby instruct the mechanical moving means 6 to position the component carried by the insertion devices precisely in the holes on the printed circuit board.

The apparatus may also be used to effect an inital alignment of the printed circuit board, by example using the sensor head 5 to locate the position of two to three known holes in the printed circuit board and using the microprocessor unit 3 to compute any errors between the actual positon of those holes and the positions stored in memory so that the printed circuit board can be correctly aligned. Alternatively, if there are surface mounted components on the printed circuit board, the positions of the edges or corners of the printed circuit board may be used.

The pattern recognition system may be applied to any number of component receiving apertures. However, the location of only one component lead receiving aperture, for example the aperture 10 in Figure 3 is required in order to correctly position a component insertion device above the desired location above a particular component.

**Claims**

1. Apparatus for preparing a component for assembly on a printed circuit board, comprising: sensing means for sensing the pattern of component lead receiving apertures on the circuit board at a desired location of a particular component; means for comparing the pattern sensed with a master pattern stored in memory means to produce a difference signal; and control means for controlling a preforming means in accordance with the difference signal to preform the leads of the component to fit the sensed pattern of component lead receiving apertures.

2. Apparatus according to Claim 1, comprising: means for effecting relative movement between a component insertion device and the printed circuit board to position the component insertion device above an area of the printed circuit board containing the desired location of the component carried by the component insertion device; sensing means for producing an image of the said area; means for comparing the image sensed with a correct image stored in memory means to produce a difference signal; and control means for controlling the moving means in response to the difference signal to position the component insertion device directly over the desired location of the component.

3. Apparatus according to Claim 1, further further comprising means for storing data representing a component to be inserted in the printed circuit board and means for comparing an image of the component produced by the sensing means with the stored data to calibrate the sensing means prior to assembly of components on the printed circuit board.

4. Apparatus according to Claim 2 or 3, further comprising means for storing data representing a plurality of preselected locations on the printed circuit board, means for comparing an image of the stored data representing the preselected locations to produce a signal to cause the control means to effect relative movement between the printed circuit board and the component insertion device to position the printed circuit board correctly prior to assembly of components on the printed circuit board.

5. A method of preparing a component for assembly on a printed circuit board, comprising: sensing the pattern of component lead receiving apertures at a desired location of a particular component; comparing the pattern sensed with a master pattern stored in memory means to produce a difference signal; and controlling a preforming means in accordance with the difference signal to preform the leads of component to fit the sensed pattern of component lead receiving apertures.

6. A method according to Claim 5, comprising: effecting relative movement between a component insertion device and the printed circuit board using moving means to position the component insertion device above an area of the printed circuit board containing the desired location of a component carried by the component insertion device; producing an image of the said area using sensing means; comparing the image sensed with a correct image stored in memory means to produce a difference signal; and controlling the moving means in response to the difference signal to position the component insertion device directly over the desired location of the component.

7. A method according to Claim 6, further comprising prior to assembling components on a printed circuit board, storing data representing a component to be inserted in the printed circuit board and comparing the stored data with an image of the component produced by the sensing means to calibrate the sensing means.

8. A method according to Claim 6 or 7, further comprising, prior to assembling components in a printed circuit board, storing data representing a plurality of preselected locations on the printed circuit board, comparing an image of the preselected locations produced by the sensing means with the stored data representing the locations to produce a signal to cause the control means to effect relative movement between the printed circuit board and the component insertion device to position the printed circuit board correctly prior to assembly of components on the printed circuit board.

**Patentansprüche**

1. Vorrichtung zum Vorbereiten eines Bauteils zum Aufbringen auf eine gedruckte Schaltkarte, mit: Mitteln zum Erfassen des Musters der die Anschlüsse des Bauteils aufnehmenden Ausnehmungen auf der gedruckten Schaltkarte an einem gewünschten Ort eines bestimmten Bauteils, Mitteln zum Vergleichen des erfaßten Musters mit einem in einem Speicher gespeicherten Muttermuster zur Erzeugung eines Differenzsignals, und Mitteln zum Steuern eines Mittels zum Verformen der Anschlüsse des Bauteils in Übereinstimmung mit dem Differenzsignal, damit diese dem erfaßten Muster der zur Aufnahme der Anschlüsse der Bauteile dienenden Ausnehmungen entsprechen.

2. Vorrichtung nach Anspruch 1, mit: Mitteln zum Bewirken einer Relativbewegung zwischen einer Einrichtung sum Einsetzen von Bauteilen und der gedruckten Schaltkarte zum Positionieren der einrichtung zum Einsetzen von Bauelementen oberhalb eines Bereiches der gedruckten Schaltkarte, der den Bestimmungsort des von der Einrichtung zum Einsetzen von Bauteilen getragenen Bauteiles beinhaltet, Mitteln, zum Erzeugen eines Bildes von diesem Bereich, Mitteln zum Vergleichen des erfaßten bildes mit einem richtigen, in einem Speicher gespeicherten Bild zum Erzeugen eines Differenzsignals, und Steuermitteln zum Steuern der Bewegungsmittel in Antwort auf das Differenzsignal zum Positionieren des Einsetzens der Komponente direkt über dem Bestimmungsort des Bauteils.

3. Vorrichtung nach Anspruch 2, weiter mit Mitteln zum Speichern von Daten, die ein in die gedruckte Schaltkarte einzusetzendes Bauteil repräsentieren und Mitteln zum Vergleichen eines von den Erfassungsmitteln erzeugtes Bildes des Bauteils mit den gespeicherten Daten, um die Erfassungsmittel vor der Aufbringung auf die gedruckte Schaltkarte einzustellen.

4. Vorrichtung nach Anspruch 2 und Anspruch 3, weiter mit Mitteln zum Speichern von eine Vielzahl von vorgegebene Positionen auf der gedruckten Schaltkarte darstellenden Daten, Mitteln zum Vergleichen eines Bildes der die vorgegebenen Orte repräsentierenden Daten zur Erzeugung eines Signals, um die Steurermittel dazu zu veranlassen, eine Relativbewegung zwischen der gedruckten Schaltkarte und der Einrichtung zum Einsetzen der Bauteile zu bewirken, um die gedruckte Schaltkarte vor der Montage der Bauteile auf die gedruckte Schaltkarte zu positionieren.

5. Verfahren zum Vorbereiten eines Bauteils zur Montage auf einer gedruckten Schaltkarte, mit: Erfassen des Musters der die Anschlüsse der Bauteile aufnehmenden Ausnehmungen an einer gewünschten Stelle eines bestimmten Bauteils, Vergleichen des erfaßten Musters mit einem in einem Speicher gespeicherten Muttermuster zum Erzeugen eines Differensignals, und Steuern einer Einrichtung zum Vorformen in Übereinstimmung mit dem Differenzsignal zum Vorformen der Anschlüsse der Bauteile, damit diese dem gemessen Muster der Ausnehmungen zur Aufnahme der Anschlüsse der Bauteile entsprechen.

6. Verfahren nach Anspruch 5, mit: Bewirken einer Relativbewegung zwischen einer Einrichtung zum Einsetzen der Komponenten und der gedruckten Schaltkarte unter Verwendung von Bewegungsmitteln zum Positionieren der Einrichtung zum Einsetzen der Bauteile oberhalb eines Bereiches der gedruckten Schaltkarte, die den Bestimmungsort eines von einer Einrichtung zum Tragen der Bauteile getragenen Komponente entspricht, Erzeugen eines Bildes des Bereiches unter Verwendung eines Erfassungsmittels, Vergleichen des erfaßten bildes mit einem in einem Speicher gespeicherten richtigen Bild zur Erzeugung eines Differenzsignals, und Steuern der Bewegungsmittel in Abhängigkeit von dem Differenzsignal zum Positionieren der Einrichtung zum Einsetzen der Komponenten direkt oberhalb des Bestimmungsortes des Bauteils.

7. Verfahren nach Anspruch 6, wobei vor dem Aufbringen der Bauteile auf die gedruckte Schaltkarte das einzusetzende Bauteil repräsentierende Daten gespeichert werden und die gespeicherten Daten mit einem Bild der Komponente, die von dem Erfassungsmittel erzeugt wird, verglichen wird, um das Erfassungsmittel einzustellen.

8. Verfahrn nach Anspruch 6 oder 7, wobei vor dem Aufbringen der Bauteile auf die gedruckte Schaltkarte eine Vielzahl von vorgewählten Orten auf der gedruckten Schaltkarte repräsentierende Daten gespeichert werden, und ein von dem Erfassungsmittel erzeugtes bild der vorgewählten Stellen repräsentierenden gespeicherten Daten mit dem die Stellen repräsentierenden Signal verglichen wird zur Erzeugung eines Signals, um die Steuermittel zu veranlassen, eine Relativbewegung zwischen der gedruckten Schaltkarte und der einrichtung zum Einsetzen der Komponente zu bewirken, um die gedruckte Schaltkarte vor der Aufbringung der Komponenten auf die gedruckte Schaltkarte zu positionieren.

**Revendications**

1. Appareil pour préparer un composant pour assemblage sur un panneau de circuit imprimé comprenant des moyens de détection pour détecter le motif formé par les ouvertures recevant les connexions des composants sur le panneau du circuit à un emplacement désiré d'un composant particulier, des moyens pour comparer le motif détecté avec un motif-maître stocké dans des moyens de mémoire pour produire un signal de différence; et des moyens de commande pour commander des moyens de préformation en concordance avec le signal de différence pour préformer les connexions du composant afin de s'adapter au motif détecté formé par les ouvertures recevant les connexions des composants.

2. Appareil conforme à la revendication 1 comprenant des moyens pour effecteur un mouvement relatif entre un dispositif d'insertion de composants et un panneau de circuit imprimé pour positionner le dispositif d'insertion de composants au-dessus d'une surface du panneau de circuit imprimé contenant l'emplacement désiré pour le composant porté par le dispositif d'insertion de composants; des moyens de détection pour produire une image desdites surfaces, des moyens pour comparer l'image détectée avec une image correcte stockée en mémoire; des moyens pour produire un signal de différence et des moyens de commande pour commander les moyens de déplacement en réponse au signal de différence pour positionner le dispositif d'insertion de composants directement sur l'emplacement désiré pour ce composant.

3. Appareil conforme à la revendication 2 comprenant en outre des moyens pour stocker des données représentant un composant à insérer dans le panneau de circuit imprimé et des moyens pour comparer une image du composant produite par les moyens de détection avec les données stockées pour calibrer les moyens de détection avant l'assemblage des composants sur le panneau de circuit imprimé.

4. Appareil conforme à la revendication 2 ou à la revendication 3 comprenant des moyens pour stocker des données représentant une pluralité d'emplacement présélecté sur un panneau de circuit imprimé; des moyens pour comparer une image des données stockées représentant les emplacements présélectés pour produire un signal commandant les moyens de commande en vue d'effectuer un mouvement relatif entre le panneau de circuit imprimé et le dispositif d'insertion de composants pour positionner le panneau de circuit imprimé correctement avant l'assemblage des composants sur le panneau de circuit imprimé.

5. Méthode pour préparer un composant pour assemblage sur un panneau de circuit imprimé comprenant la détection du motif formé par les ouvertures recevant les connexions des composants a un emplacement désiré d'un composant particulier, la comparaison du motif détecté avec un motif-maître stocké dans des moyens de mémoire pour produire un signal de différence; et la commande de moyens de préformation en concordance avec le signal de différence pour préformer les connexions du composant afin de s'adapter au motif détecté formé par les ouvertures recevant les connexions des composants.

6. Méthode conforme à la revendication 5 comprenant la mise en mouvement relative entre un dispositif d'insertion de composants et un panneau de circuit imprimé en utilisant des moyens de déplacement pour positionner le dispositif d'insertion de composants au-dessus d'une surface du panneau de circuit imprimé contenant l'emplacement désiré pour le composant porté par le dispositif d'insertion de composants; la production d'une image desdites surfaces, en utilisant des moyens de détection; la comparaison de l'image détectée avec une image correcte stockée dans les moyens de mémoire; la production d'un signal de différence; et la commande des moyens de déplacement en réponse au signal de différence pour positionner le dispositif d'insertion de composants directement sur l'emplacement désiré pour ce composant.

7. Méthose conforme à la revendication 6 comprenant en outre avant l'assemblage des composants sur un panneau de circuit imprimé la mise en mémoire de données représentant un composant à insérer dans le panneau de circuit imprimé et la comparaison des données stockées avec une image du composant produite par les moyens de détection pour calibrer ces moyens de détection.

8. Méthode conforme à la revendication 7 comprenant en outre avant l'assemblage des composants sur un panneau de circuit imprimé la mise en mémoire de données représentant une pluralité d'emplacements présélectés sur le panneau de circuit imprimé la comparaison d'une image des emplacements présélectés produite par les moyens de détection avec les données stockées représentant ces emplacements pour produire un signal commandant les moyens de commande en vue d'effectuer un mouvement relatif entre le panneau de circuit imprimé et le dispositif d'insertion de composants pour positionner le panneau de circuit imprimé correctement avant l'assemblage des composants sur le panneau de circuit imprimé.

*Fig.1.*

*Fig.2.*

0 138 863

*Fig. 3.*

*Fig. 4.*